# EUROPEAN PATENT SPECIFICATION

(11) **EP 4 212 897 B1**
(45) Date of publication and mention of the grant of the patent: **24.12.2025**
(21) Application number: 22756440.8
(22) Date of filing: 14.02.2022
(51) Int. Cl.: G01R 31/392, G01R 31/382, G01R 1/20, G01R 19/00, G01R 19/165, G01R 1/30, H02J 7/00, H01M 10/42

(54) **BATTERY MANAGEMENT APPARATUS**
BATTERIEVERWALTUNGSVORRICHTUNG
APPAREIL DE GESTION DE BATTERIE

(30) Priority: 22.02.2021 KR 20210023639
(43) Date of publication of application: 19.07.2023
(60) Divisional application: 25208771.3
(73) Proprietor: LG Energy Solution, Ltd., Seoul 07335 (KR)
(72) Inventor: KANG, Yeong Ju, Daejeon 34122 (KR); KIM, Tae Soo, Daejeon 34122 (KR); JANG, Man Hoo, Daejeon 34122 (KR)
(74) Representative: Goddar, Heinz J.
(86) International application number: PCT/KR2022/002133
(87) International publication number: WO 2022/177241

(56) References cited:
- EP-A1- 3 771 067
- WO-A1-2019/245215
- JP-A- 2018 097 973
- JP-A- H1 198 701
- JP-A- H11 133 126
- KR-A- 20130 137 389
- KR-A- 20190 101 635
- KR-A- 20200 002 351
- KR-B1- 101 585 453
- US-A1- 2015 256 070
- US-A1- 2018 299 510

## Description

### [Technical Field]

### CROSS-REFERENCE TO RELATED APPLICATION

This application claims priority to and the benefit of Korean Patent Application No. 10-2021-0023639 filed in the Korean Intellectual Property Office on February 22, 2021.

### TECHNICAL FIELD

The present disclosure relates to a battery management apparatus.

### [Background Art]

Recently, research and development of secondary batteries have been actively performed. Herein, the secondary batteries, which are chargeable/dischargeable batteries, may include all of conventional nickel (Ni)/cadmium (Cd) batteries, Ni/metal hydride (MH) batteries, etc., and recent lithium-ion batteries. Among the secondary batteries, a lithium-ion battery has a much higher energy density than those of the conventional Ni/Cd batteries, Ni/MH batteries, etc. Moreover, the lithium-ion battery may be manufactured to be small and lightweight, such that the lithium-ion battery has been used as a power source of mobile devices, and recently, a use range thereof has been extended to power sources for electric vehicles, attracting attention as next-generation energy storage media.

Meanwhile, when over-current flows in the case of charging or discharging of a lithium-ion battery, the internal temperature of the battery increases, leading to a fire in a vehicle equipped with the battery. To prevent this situation, an over-current detection function for continuously determining whether the over-current flows in the battery is required, and the operational integrity of the over-current detection function also has to be guaranteed. JP H11 133126 A describes a battery management apparatus with over-current detection capability via the use of a shunt resistor that is connected to a secondary battery. It comprises further a current measurement circuit, an over-current current protection circuit and a voltage measurement circuit. The charging current of the secondary battery detected by the differential amplifier is compared with the first reference value and the second reference value in the first and second comparators, respectively. Similarly, the discharge current of the secondary battery detected by the differential amplifier is compared with the first reference value and the second reference value in the third and fourth comparators.

### [Disclosure]

### [Technical Problem]

Embodiments disclosed herein aim to provide a battery management apparatus capable of diagnosing an operation of an over-current detection function of a battery.

Technical problems of the embodiments disclosed herein are not limited to the above-described technical problems, and other unmentioned technical problems would be clearly understood by one of ordinary skill in the art from the following description.

### [Technical Solution]

A battery management apparatus according to an embodiment disclosed herein includes a shunt resistor connected to a battery and a voltage generation unit configured to generate a first output value and a second output value which have a difference therebetween corresponding to a magnitude of a voltage applied to the shunt resistor, in which the difference between the first output value and the second output value corresponds to the magnitude of the voltage applied to the shunt resistor when a charging over-current or a discharging over-current flows in the shunt resistor.

The voltage generation unit is further configured to generate the first output value and the second output value in a state where a charging over-current or a discharging over-current does not flow in the shunt resistor. A determination unit is configured to receive the first output value and the second output value and to determine whether the charging over-current or the discharging over-current flows in the shunt resistor, wherein when the determination unit fails to determine that the over-current flows in the shunt resistor in spite of reception of the first output value and the second output value from the voltage generation unit, it is diagnosed that the determination unit fails to normally perform the over-current.

In an embodiment, the voltage generation unit may be further configured to generate the first output value that is a difference between the magnitude of the voltage applied to the shunt resistor and a voltage of the battery when the charging over-current flows in the shunt resistor, and to generate the second output value that is equal to the voltage of the battery.

In an embodiment, the voltage generation unit may be further configured to generate the first output value that is equal to the voltage of the battery and to generate the second output value that is a difference between the voltage applied to the shunt resistor and the voltage of the battery when the discharging over-current flows in the shunt resistor.

In an embodiment, the determination unit may include an amplifier configured to receive and amplify the first output value and the second output value, a comparator configured to compare an output of the amplifier with a reference value, and a controller configured to determine whether the charging over-current or the discharging over-current flows in the shunt resistor, based on the output of the amplifier or the comparator.

In an embodiment, the voltage generation unit may include a plurality of resistors and a plurality of switches, and the plurality of switches may include any one of a negative-positive-negative (NPN)-type bipolar junction transistor (BJT), a positive-negative-positive (PNP)-type BJT, and a metal-oxide-semiconductor field-effect transistor (MOSFET).

A battery management apparatus according to an embodiment disclosed herein includes a shunt resistor connected to a battery, a first resistor connected to the shunt resistor at a first node, a second resistor connected to the first resistor at a second node, a third resistor connected to the shunt resistor at a third node, a fourth resistor connected to the third resistor at a fourth node, a first switch connected to the second resistor, a second switch connected to the fourth resistor, and a determination unit configured to receive a voltage of the second node and a voltage of the fourth node by means of the control of the first switch and the second switch and to determine whether over-current flows in the shunt resistor.

In an embodiment, the determination unit may include an amplifier configured to receive the voltage of the second node and the voltage of the fourth node and to amplify a difference therebetween, a comparator configured to compare an output of the amplifier with a reference value, and a controller configured to determine whether the charging over-current or the discharging over-current flows in the shunt resistor, based on the output of the amplifier or the comparator.

In an embodiment, the controller may be further configured to control the first switch and the second switch, to short-circuit the first switch and to open the second switch to detect the charging over-current, and to short-circuit the second switch and to open the first switch to detect the discharging over-current.

In an embodiment, the controller may be further configured to open both the first switch and the second switch in a situation where the battery is charged or discharged.

In an embodiment, the battery management apparatus may further include a relay connected to the shunt resistor, in which the relay is controlled by a control signal of the controller, and the controller is further configured to open the relay when the first switch or the second switch is short-circuited.

In an embodiment, the first switch and the second switch may include any one of a PNP-type BJT, an NPN-type BJT, and a MOSFET.

In an embodiment, magnitudes of the first resistor and the second resistor may be set such that a difference between a magnitude of the voltage of the second node and a magnitude of the voltage of the battery corresponds to the magnitude of the voltage applied to the shunt resistor when the over-current flows during charging of the battery, and magnitudes of the third resistor and the fourth resistor may be set such that a difference between a magnitude of the voltage of the fourth node and the magnitude of the voltage of the battery corresponds to the magnitude of the voltage applied to the shunt resistor when the over-current flows during discharging of the battery.

### [Advantageous Effects]

The battery management apparatus according to an embodiment disclosed herein may diagnose an operation of an over-current detection function of a battery.

### [Description of Drawings]

FIG. 1 illustrates a battery pack according to an embodiment disclosed herein.
FIGS. 2 and 3 illustrate a battery management system according to embodiments disclosed herein.
FIG. 4 is a view for describing in detail a voltage generation unit in a battery management system, according to an embodiment disclosed herein.
FIG. 5 is a view for describing a determination unit in a battery management apparatus, according to an embodiment disclosed herein.

### [Mode for Invention]

Hereinafter, embodiments disclosed in this document will be described in detail with reference to the exemplary drawings. In adding reference numerals to components of each drawing, it should be noted that the same components are given the same reference numerals even though they are indicated in different drawings. In addition, in describing the embodiments disclosed in this document, when it is determined that a detailed description of a related known configuration or function interferes with the understanding of an embodiment disclosed in this document, the detailed description thereof will be omitted.

To describe a component of an embodiment disclosed herein, terms such as first, second, A, B, (a), (b), etc., may be used. These terms are used merely for distinguishing one component from another component and do not limit the component to the essence, sequence, order, etc., of the component. The terms used herein, including technical and scientific terms, have the same meanings as terms that are generally understood by those skilled in the art, as long as the terms are not differently defined. Generally, the terms defined in a generally used dictionary should be interpreted as having the same meanings as the contextual meanings of the relevant technology and should not be interpreted as having ideal or exaggerated meanings unless they are clearly defined in the present application.

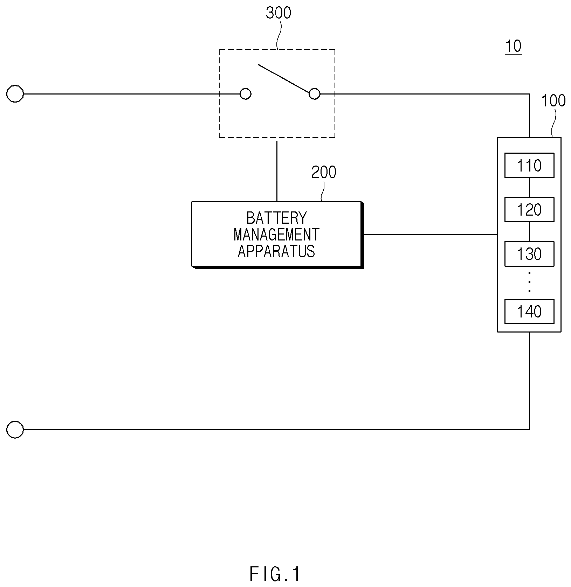

FIG. 1 illustrates a battery pack according to an embodiment disclosed herein.

Referring to FIG. 1, a battery pack 10 according to an embodiment disclosed herein may include a battery module 100, a battery management apparatus 200, and a relay 300.

The battery module 100 may include a plurality of battery cells 110, 120, 130, and 140. Although the plurality of battery cells are illustrated as four in FIG. 1, the present disclosure is not limited thereto, and the battery module 100 may include n battery cells (n is a natural number greater than or equal to 2). The battery module 100 may supply power to a target device (not shown). To this end, the battery module 100 may be electrically connected to the target device. Herein, the target device may include an electrical, electronic, or mechanical device that operates by receiving power from the battery pack 10 including the plurality of battery cells 110, 120, 130, and 140, and the target device may be, for example, an electric vehicle (EV), but is not limited thereto.

The plurality of battery cells 110, 120, 130, and 140 may be a lithium ion (Li-ion) battery, an Li-ion polymer battery, a nickel-cadmium (Ni-Cd) battery, a nickel hydrogen (Ni-MH) battery, etc., and are not limited thereto. Meanwhile, although one battery module 100 is illustrated in FIG. 1, the battery module 100 may be configured in plural according to an embodiment.

The battery management apparatus 200 may manage and/or control a state and/or an operation of the battery module 100. For example, the battery management apparatus 200 may manage and/or control the states and/or operations of the plurality of battery cells 110, 120, 130, and 140 included in the battery module 100. The battery management apparatus 200 may manage charging and/or discharging of the battery module 100.

In addition, the battery management apparatus 200 may monitor a voltage, a current, a temperature, an insulation resistance, etc., of the battery pack 10, the battery module 100 and/or each of the plurality of battery cells 110, 120, 130, and 140 included in the battery module 100. A sensor or various measurement modules for monitoring performed by the battery management apparatus 200, which are not shown, may be additionally installed in a charging/discharging path, any position of the battery module 100, etc. The battery management apparatus 200 may calculate a parameter indicating a state of the battery module 100, e.g., a state of charge (SOC), a state of health (SOH) etc., based on a measurement value such as monitored voltage, current, temperature, etc.

The battery management apparatus 200 may control an operation of the relay 300. For example, the battery management apparatus 200 may short-circuit the relay 300 to supply power to the target device. The battery management apparatus 200 may short-circuit the relay 300 when a charging device is connected to the battery pack 10.

The battery management apparatus 200 may diagnose whether an over-current detection function operates normally. To this end, the battery management apparatus 200 may detect whether over-current flows in the battery module 100 when the battery module 100 is charged or discharged. The battery management apparatus 200 may open the relay 300 when the over-current is detected in the battery module 100. Thus, the battery management apparatus 200 may determine whether the over-current detection function operates normally, and may improve ISO26262 and an Automotive Safety Integrity Level (ASIL) safety level.

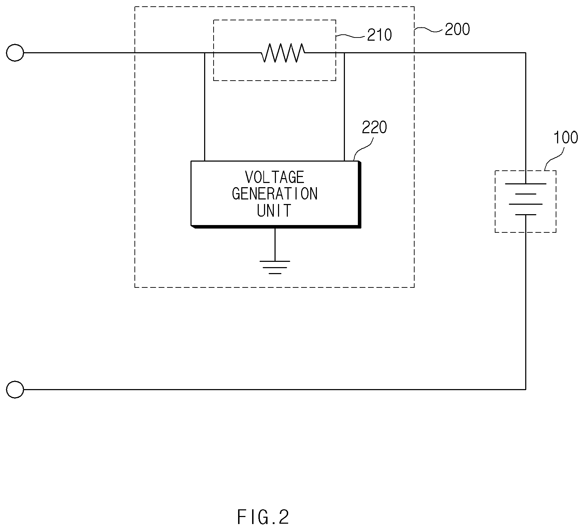

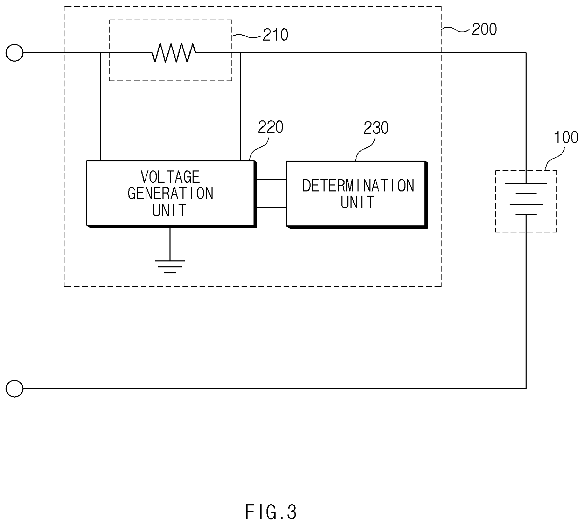

Hereinbelow, a detailed operation of the battery management apparatus 200 will be described with reference to FIGS. 2 and 3.

FIGS. 2 and 3 illustrate a battery management system according to an embodiment disclosed herein.

Referring to FIG. 2, the battery management apparatus 200 according to an embodiment disclosed herein may include a shunt resistor 210 and a voltage generation unit 220.

The shunt resistor 210 may sense current flowing in a circuit. For example, by measuring a voltage applied to the shunt resistor 210 with respect to current flowing in the circuit, the magnitude of the current flowing in the circuit may be sensed. The shunt resistor 210 may be connected to the battery module 100.

The voltage generation unit 220 may generate a first output value and a second output value. The voltage generation unit 220 may be connected to both terminals of the shunt resistor 210. The voltage generation unit 220 may generate the first output value and the second output value which have a difference therebetween corresponding to a magnitude of the voltage applied to the shunt resistor 210 when charging over-current or discharging over-current flows in the shunt resistor 210. That is, the difference between the first output value and the second output value may correspond to the magnitude of the voltage applied to the shunt resistor 210 when the charging over-current or the discharging over-current flows in the shunt resistor 210.

According to an embodiment, the voltage generation unit 220 may generate the first output value and the second output value when the charging over-current or the discharging over-current does not flow in the shunt resistor 210. For example, the battery management apparatus 200 may diagnose a charging over-current or discharging over-current detection function based on the first output value and the second output value that are generated when the charging over-current or the discharging over-current does not flow in the shunt resistor 210.

Herein, the charging over-current may be defined as over-current that flows in the battery module 100, a circuit connected to the battery module 100, and/or a device connected to the battery module 100 during charging of the battery module 100. Moreover, the discharging over-current may be defined as over-current that flows in the battery module 100, a circuit connected to the battery module 100, and/or a device connected to the battery module 100, etc., during discharging of the battery module 100. For example, in the battery management apparatus 200, levels of charging over-current and discharging over-current may be preset values.

According to an embodiment, the voltage generation unit 220 may generate a first output value that is a difference between a magnitude of the voltage applied to the shunt resistor 210 and a voltage of a battery when the charging over-current flows in the shunt resistor 210. For example, the voltage generation unit 220 may generate a first output value that is less than the magnitude of the voltage of the battery module 100 by the magnitude of the voltage applied to the shunt resistor 210 when the charging over-current flows in the shunt resistor 210. That is, the first output value may be obtained by subtracting the magnitude of the voltage applied to the shunt resistor 210 from the voltage of the battery module 100 when the charging over-current flows in the shunt resistor 210. Moreover, the voltage generation unit 220 may generate a second output value that is equal to the voltage of the battery. For example, the voltage generation unit 220 may generate the second output value having a magnitude corresponding to the magnitude of the voltage of the battery module 100.

The battery management apparatus 200 may detect the charging over-current based on the first output value and the second output value that are generated in the voltage generation unit 220.

According to an embodiment, the voltage generation unit 220 may generate the second output value that is equal to the voltage of the battery. For example, the voltage generation unit 220 may generate the first output value having a magnitude corresponding to the magnitude of the voltage of the battery module 100. In addition, the voltage generation unit 220 may generate the second output value that is a difference between the voltage applied to the shunt resistor 210 and the voltage of the battery when the discharging over-current flows in the shunt resistor 210. For example, the voltage generation unit 220 may generate the second output value that is less than the magnitude of the voltage of the battery module 100 by the magnitude of the voltage applied to the shunt resistor 210 when the discharging over-current flows in the shunt resistor 210. That is, the second output value may be obtained by subtracting the magnitude of the voltage applied to the shunt resistor 210 from the voltage of the battery module 100 when the discharging over-current flows in the shunt resistor 210.

The battery management apparatus 200 may detect the discharging over-current based on the first output value and the second output value that are generated in the voltage generation unit 220.

Meanwhile, according to an embodiment, the voltage generation unit 220 may be implemented with a plurality of resistors and a plurality of switches. For example, the plurality of switches may be any one of a negative-positive-negative (NPN)-type bipolar junction transistor (BJT), a positive-negative-positive (PNP)-type BJT, and a metal-oxide-semiconductor field-effect transistor (MOSFET).

Referring to FIG. 3, the battery management apparatus according to an embodiment disclosed herein may further include a determination unit 230 in addition to the shunt resistor 210 and the voltage generation unit 220.

The determination unit 230 may determine whether the over-current flows in the shunt resistor 210, based on the first output value and the second output value generated in the voltage generation unit 220. That is, in a situation where the charging over-current or the discharging over-current does not directly flow in the shunt resistor 210, the voltage generation unit 220 may generate the applied voltage when the charging over-current or the discharging over-current flows in the shunt resistor 210, and the determination unit 230 may receive the generated first output value and second output value and determine whether the over-current flows in the shunt resistor 210.

Thus, it may be diagnosed whether the determination unit 230 normally performs the over-current detection function. When the determination unit 230 fails to determine that the over-current flows in the shunt resistor 210 in spite of reception of the first output value and the second output value from the voltage generation unit 220, it is diagnosed that the determination unit 230 fails to normally perform the over-current detection function.

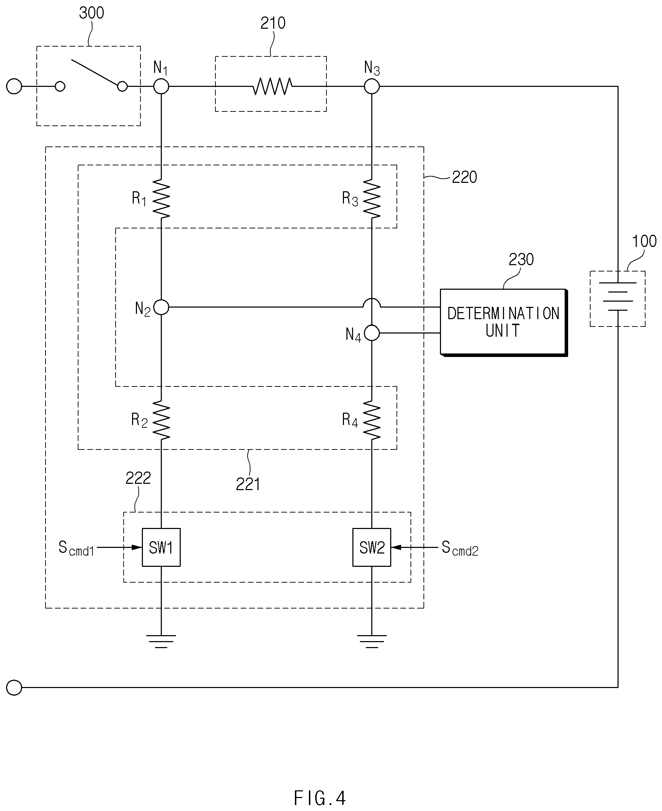

The voltage generation unit 220 in the battery management apparatus 200 will now be described in detail with reference to FIG. 4.

FIG. 4 is a view for describing in detail a voltage generation unit in a battery management system, according to an embodiment disclosed herein.

Referring to FIG. 4, the voltage generation unit 220 according to an embodiment disclosed herein may include the plurality of resistors 221 and the plurality of resistors 222.

The plurality of resistors 221 (R₁, R₂, R₃, and R₄) may be connected to both terminals of the shunt resistor 210. More specifically, the first resistor R₁ may be connected to the shunt resistor 210 at a first node N₁. The second resistor R₂ may be connected to the first resistor R₁ at a second node N₂. The third resistor R₃ may be connected to the shunt resistor 210 at a third node N₃. The fourth resistor R₄ may be connected to the third resistor R₃ at a fourth node N₄.

The values of the plurality of resistors 221 may be set to distribute the voltage of the battery module 100 based on the levels of the charging over-current and the discharging over-current.

For example, the magnitudes of the first resistor R₁ and the second resistor R₂ may be set such that a difference between the magnitude of the voltage applied to the second node N₂ and the magnitude of the voltage of the battery module 100 corresponds to the magnitude of the voltage applied to the shunt resistor 210 when the charging over-current flows in the shunt resistor 210. Moreover, the magnitudes of the third resistor R₃ and the fourth resistor R₄ may be set such that a difference between the magnitude of the voltage applied to the fourth node N₄ and the magnitude of the voltage of the battery module 100 corresponds to the magnitude of the voltage applied to the shunt resistor 210 when the discharging over-current flows in the shunt resistor 210.

Meanwhile, it is shown in FIG. 4 that the plurality of resistors 221 includes the first resistor R₁, the second resistor R₂, the third resistor R₃, and the fourth resistor R₄, the present disclosure is not limited thereto. For example, at least one of the first resistor R₁, the second resistor R₂, the third resistor R₃, and the fourth resistor R₄ may include a plurality of resistors.

The plurality of switches 222 (SW1 and SW2) may be connected to the plurality of resistors 221, respectively. More specifically, the first switch SW1 may be connected to the second resistor R₂, and the second switch SW2 may be connected to the fourth resistor R₄.

Meanwhile the plurality of switches 222 may be any one of a PNP-type BJT, an NPN-type BJT, and a MOSFET. For example, the plurality of switches 222 may be a PNP-type BJT.

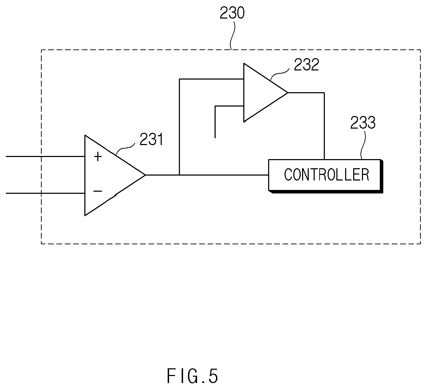

The plurality of switches 222 may be controlled by control signals S_{cmd1} and S_{cmd2}. For example, the first switch SW1 may be controlled by the first control signal S_{cmd1}, and the second switch SW2 may be controlled by the second control signal S_{cmd2}. The control signals S_{cmd1} and S_{cmd2} may be generated in a controller 233 (see FIG. 5). However, the present disclosure is not limited thereto, and a first controller and a second controller may exist to generate the first control signal S_{cmd1} and the second control signal S_{cmd2}, respectively, to control the first switch SW1 and the second switch SW2.

The controller 233 may short-circuit the first switch SW1 and open the second switch SW2 to detect the charging over-current. Moreover, the controller 233 may short-circuit the second switch SW2 and open the first switch SW1 to detect the discharging over-current.

When the battery module 100 is charged or discharged, the first switch SW1 and the second switch SW2 may be opened by the control signals S_{cmd1} and S_{cmd2}. When the first switch SW1 and the second switch SW2 are opened, the voltage of the first node N₁ may be applied to the second node N₂ and the voltage of the third node N₃ may be applied to the fourth node N₄, such that the determination unit 230 may receive the magnitude of the voltage applied to the both terminals of the shunt resistor 210. That is, the determination unit 230 may determine whether the charging over-current or the discharging over-current flows in the shunt resistor 210 when the battery module 100 is charged or discharged.

The determination unit 230 may receive the voltages applied to the second node N₂ and the fourth node N₄ and determine whether the charging over-current or the discharging over-current flows in the shunt resistor 210, based on the received voltages. That is, the battery management apparatus 200 may determine whether the determination unit 230 normally operates based on the voltages distributed to the second node N2 and the fourth node N4 in a situation where the charging over-current or the discharging over-current does not directly flow in the shunt resistor 210.

The determination unit 230 will now be described in detail with reference to FIG. 5.

FIG. 5 is a view for describing a determination unit in a battery management apparatus, according to an embodiment disclosed herein.

Referring to FIG. 5, in the battery management apparatus 200 according to an embodiment disclosed herein, the determination unit 230 may include an amplifier 231, a comparator 232, and a controller 233.

The amplifier 231 may amplify the difference between the first output value and the second output value delivered from the voltage generation unit 220. For example, the amplifier 231 may amplify a value obtained by subtracting the second output value from the first output value. The amplifier 231 may include an operational amplifier (OP-AMP).

For example, the amplifier 231 may receive the voltages applied to the second node N₂ and the fourth node N₄. In this case, the magnitude of the voltage of the second node N₂ may correspond to the first output value, and the magnitude of the voltage of the fourth node N₄ may correspond to the second output value.

The comparator 232 may receive an output of the amplifier 231 to compare the received output with a reference value, and output a comparison result. For example, when the output of the amplifier 231 is greater than the reference value, the comparator 232 may output a first value, and when the output of the amplifier 231 is less than the reference value, the comparator 232 may output a second value. Herein, the reference value may be set equally or differently according to when the charging over-current is detected and when the discharging over-current is detected.

The controller 233 may receive the output of the amplifier 231 and convert the received output into a digital signal, and compare the digital signal with a preset value to determine whether the charging over-current or the discharging over-current flows in the shunt resistor 210. The controller 233 may determine whether the charging over-current or the discharging over-current flows in the shunt resistor 210, based on the output of the amplifier 231, when both the first switch SW1 and the second switch SW2 are opened. For example, the controller 233 may be implemented with a microcontroller or an analog-to-digital converter (ADC) that receives the output of the amplifier 231.

Moreover, the controller 233 may determine whether the charging over-current or the discharging over-current flows in the shunt resistor 210, based on a comparison result output from the comparator 232. For example, the controller 233 may determine that the charging over-current flows in the shunt resistor 210, when the comparison result has a first value. That is, the controller 233 may determine whether the charging over-current or the discharging over-current flows in the shunt resistor 210, based on the comparison result of the comparator 232, when the first switch SW1 or the second switch SW2 is short-circuited.

Meanwhile, the controller 233 may generate a control signal for controlling the plurality of switches 222. For example, the controller 233 may generate the first control signal S_{cmd1} to control the first switch SW1, and may generate the second control signal S_{cmd2} to control the second switch SW2.

As a result, the controller 233 may determine whether the amplifier 231 and the comparator 232 operate normally, based on the first output value and the second output value input from the voltage generation unit 220, in a situation where the over-current does not flow in the shunt resistor 210. That is, the battery management apparatus 200 may guide a user when a charging over-current or discharging over-current detection function does not operate normally. In this way, it may be diagnosed whether the determination unit 230 normally performs the over-current detection function.

Meanwhile, the controller 233 may open the relay 300 when the battery module 100 is not charged or discharged. For example, the controller 233 may generate a control signal for opening the relay 300.

The controller 233 may generate the control signals S_{cmd1} and S_{cmd2} in a state where the relay 300 is opened, to alternately short-circuit the first switch SW1 and the second switch SW2, thus diagnosing whether the charging over-current detection function or the discharging over-current detection function operates.

Hereinbelow, diagnosis of the over-current detection function among operations of the circuit will be described based on a structure of the battery management apparatus 200.

As described above, the battery management apparatus 200 according to an embodiment disclosed herein may diagnose the over-current detection function. The battery management apparatus 200 may open the relay 300 and perform diagnosis of the charging over-current or discharging over-current detection function when the battery module 100 is not charged or discharged.

The battery management apparatus 200 may diagnose the charging over-current detection function. To diagnose the charging over-current detection function, the controller 233 may generate the plurality of control signals S_{cmd1} and S_{cmd2} to short-circuit the first switch SW1 and open the second switch SW2. When the first switch SW1 is short-circuited, the voltage of the battery module 100 may be distributed by the shunt resistor 210, the first resistor R₁, and the second resistor R₂, and the distributed voltage may be applied to the second node N₂. However, the magnitude of the voltage applied to the shunt resistor 210 may be much less than those of the voltages applied to the first resistor R₁ and the second resistor R₂. When the second switch SW2 is opened, the voltage of the battery module 100 may be applied to the fourth node N₄.

As described above, the magnitudes of the first resistor R₁ and the second resistor R₂ may be set such that a difference between the voltage applied to the second node N₂ and the voltage of the battery module 100 corresponds to the magnitude of the voltage applied to the shunt resistor 210 when the charging over-current flows in the shunt resistor 210. The voltage applied to the second node N₂ and the voltage applied to the fourth node N₄ may be input to the amplifier 231, and the amplifier 231 may amplify a difference between the voltage applied to the second node N₂ and the voltage applied to the fourth node N₄ and the amplified voltage may be input to the comparator 232. The comparator 232 may compare the magnitude of the amplified voltage with a first reference value. The output of the comparator 232 may be input to the controller 233, and the controller 233 may determine whether the charging over-current flows in the shunt resistor 210, based on the output of the comparator 232.

That is, the difference between the voltage applied to the second node N₂ and the voltage applied to the fourth node N₄ corresponds to the magnitude of the voltage applied to the shunt resistor 210 when the charging over-current flows in the shunt resistor 210, such that the battery management apparatus 200 may diagnose an operation of the charging over-current detection function in a situation where the charging over-current does not directly flow in the shunt resistor 210.

The battery management apparatus 200 may diagnose the discharging over-current detection function. To diagnose the discharging over-current detection function, the controller 233 may generate the plurality of control signals S_{cmd1}and S_{cmd2} to open the first switch SW1 and short-circuit the second switch SW2. When the second switch SW2 is short-circuited, the voltage of the battery module 100 may be distributed by the third resistor R₃ and the fourth resistor R₄, and the distributed voltage may be applied to the fourth node N₄. When the first switch SW1 is opened, the voltage of the battery module 100 may be applied to the second node N₂.

As described above, the magnitudes of the third resistor R₃ and the fourth resistor R₄ may be set such that a difference between the voltage applied to the fourth node N₄ and the voltage of the battery module 100 corresponds to the magnitude of the voltage applied to the shunt resistor 210 when the discharging over-current flows in the shunt resistor 210. The voltage applied to the second node N₂ and the voltage applied to the fourth node N₄ may be input to the amplifier 231, and the amplifier 231 may amplify the difference between the voltage applied to the second node N₂ and the voltage applied to the fourth node N₄ and the amplified voltage may be input to the comparator 232 for comparison with a second reference value. The output of the comparator 232 may be input to the controller 233, and the controller 233 may determine whether the discharging over-current flows in the shunt resistor 210, based on the output of the comparator 232.

That is, the difference between the voltage applied to the second node N₂ and the voltage applied to the fourth node N₄ corresponds to the magnitude of the voltage applied to the shunt resistor 210 when the discharging over-current flows in the shunt resistor 210, such that the battery management apparatus 200 may diagnose an operation of the discharging over-current detection function in a situation where the discharging over-current does not directly flow in the shunt resistor 210.

As described above, the battery management apparatus 200 may diagnose the operation of the charging over-current or discharging over-current detection function in a situation where the charging over-current or the discharging over-current does not directly flow in the shunt resistor 210. Thus, the battery management apparatus 200 may identify the integrity of the over-current detection function.

The above description is merely illustrative of the technical idea of the present disclosure, and various modifications and variations will be possible without departing from the essential characteristics of embodiments of the present disclosure as defined by the appended claims.

Therefore, the embodiments disclosed herein are intended for description and the scope of the present disclosure is not limited by these embodiments disclosed herein. The protection scope disclosed herein should be interpreted by the following claims.

## Claims

1. A battery management apparatus (200) comprising:
a shunt resistor (210) connected to a battery;
a voltage generation unit (220) configured to generate a first output value and a second output value which have a difference therebetween corresponding to a magnitude of a voltage applied to the shunt resistor (210),
wherein the voltage generation unit (220) is further configured to generate the first output value and the second output value in a state where a charging over-current or a discharging over-current does not flow in the shunt resistor (210),
wherein the difference between the first output value and the second output value corresponds to the magnitude of the voltage applied to the shunt resistor (210) when a charging over-current or a discharging over-current flows in the shunt resistor (210); and
a determination unit (230) configured to receive the first output value and the second output value and to determine whether the charging over-current or the discharging over-current flows in the shunt resistor (210),
wherein when the determination unit (230) fails to determine that the over-current flows in the shunt resistor (210) in spite of reception of the first output value and the second output value from the voltage generation unit (220), it is diagnosed that the determination unit (230) fails to normally perform the over-current.

2. The battery management apparatus (200) of claim 1, wherein the voltage generation unit (220) is configured to generate the first output value that is a difference between the magnitude of the voltage applied to the shunt resistor (210) when the charging over-current flows in the shunt resistor (210) and a voltage of the battery, and to generate the second output value that is equal to the voltage of the battery.

3. The battery management apparatus (200) of claim 1, wherein the voltage generation unit (220) is configured to generate the first output value that is equal to the voltage of the battery and to generate the second output value that is a difference between the voltage applied to the shunt resistor (210) when the discharging over-current flows in the shunt resistor (210) and the voltage of the battery.

4. The battery management apparatus (200) of claim 1, wherein the determination unit (230) comprises:
an amplifier (231) configured to receive and amplify the first output value and the second output value;
a comparator (232) configured to compare an output of the amplifier (231) with a reference value; and
a controller (233) configured to determine whether the charging over-current or the discharging over-current flows in the shunt resistor (210), based on the output of the amplifier (231) or the comparator (232).

5. The battery management apparatus (200) of claim 1, wherein the voltage generation unit (220) comprises a plurality of resistors and a plurality of switches (222), and the plurality of switches (222) comprise any one of a negative-positive-negative (NPN)-type bipolar junction transistor (BJT), a positive-negative-positive (PNP)-type BJT, and a metal-oxide-semiconductor field-effect transistor (MOSFET).

6. A battery management apparatus (200) comprising:
a shunt resistor (210) connected to a battery;
a first resistor (R1) connected to the shunt resistor (210) at a first node (N₁);
a second resistor (R2) connected to the first resistor (R1) at a second node (N₂);
a third resistor (R3) connected to the shunt resistor (210) at a third node (N₃);
a fourth resistor (R4) connected to the third resistor (R3) at a fourth node (N₄);
a first switch (SW1) connected to the second resistor (R2);
a second switch (SW2) connected to the fourth resistor (R4); and
a determination unit (230) configured to receive a voltage of the second node (N₂) and a voltage of the fourth node (N₄) by means of the control of the first switch (SW1) and the second switch (SW2) and to determine whether over-current flows in the shunt resistor (210).

7. The battery management apparatus (200) of claim 6, wherein the determination unit (230) comprises:
an amplifier (231) configured to receive the voltage of the second node (N₂) and the voltage of the fourth node (N₄) and to amplify a difference therebetween;
a comparator (232) configured to compare an output of the amplifier (231) with a reference value; and
a controller (233) configured to determine whether the charging over-current or the discharging over-current flows in the shunt resistor (210), based on the output of the amplifier (231) or the comparator (232).

8. The battery management apparatus (200) of claim 7, wherein the controller (233) is configured to control the first switch (SW1) and the second switch (SW2), to short-circuit the first switch (SW1) and to open the second switch (SW2) to detect the charging over-current, and to short-circuit the second switch (SW2) and to open the first switch (SW1) to detect the discharging over-current.

9. The battery management apparatus (200) of claim 8, wherein the controller (233) is configured to open both the first switch (SW1) and the second switch (SW2) in a situation where the battery is charged or discharged.

10. The battery management apparatus (200) of claim 8, further comprising a relay connected to the shunt resistor (210),
wherein the relay is controlled by a control signal of the controller (233), and the controller (233) is configured to open the relay when the first switch (SW1) or the second switch (SW2) is short-circuited.

11. The battery management apparatus (200) of claim 6, wherein the first switch (SW1) and the second switch (SW2) comprise any one of a positive-negative-positive (PNP)-type bipolar junction transistor (BJT), a negative-positive-negative (NPN)-type BJT, and a metal-oxide-semiconductor field-effect transistor (MOSFET).

12. The battery management apparatus (200) of claim 6, wherein magnitudes of the first resistor (R1) and the second resistor (R2) are set such that a difference between a magnitude of the voltage of the second node (N₂) and a magnitude of the voltage of the battery corresponds to the magnitude of the voltage applied to the shunt resistor (210) when the over-current flows during charging of the battery, and magnitudes of the third resistor (R3) and the fourth resistor (R4) are set such that a difference between a magnitude of the voltage of the fourth node (N₄) and the magnitude of the voltage of the battery corresponds to the magnitude of the voltage applied to the shunt resistor (210) when the over-current flows during discharging of the battery.

## Patentansprüche

1. Batteriemanagementvorrichtung (200) aufweisend:
einen Nebenschlusswiderstand (210), der mit einer Batterie verbunden ist;
eine Spannungserzeugungseinheit (220), die konfiguriert ist, um einen ersten Ausgabewert und einen zweiten Ausgabewert zu erzeugen, die eine Differenz dazwischen aufweisen, die einer Größe einer an den Nebenschlusswiderstand (210) angelegten Spannung entspricht,
wobei die Spannungserzeugungseinheit (220) ferner konfiguriert ist, um den ersten Ausgabewert und den zweiten Ausgabewert in einem Zustand zu erzeugen, in dem ein Ladeüberstrom oder ein Entladeüberstrom nicht in dem Nebenschlusswiderstand (210) fließt,
wobei die Differenz zwischen dem ersten Ausgabewert und dem zweiten Ausgabewert der Größe der an den Nebenschlusswiderstand (210) angelegten Spannung entspricht, wenn ein Ladeüberstrom oder ein Entladeüberstrom in dem Nebenschlusswiderstand (210) fließt; und
eine Bestimmungseinheit (230), die konfiguriert ist, um den ersten Ausgabewert und den zweiten Ausgabewert zu empfangen und zu bestimmen, ob der Ladeüberstrom oder der Entladeüberstrom in dem Nebenschlusswiderstand (210) fließt,
wobei, wenn die Bestimmungseinheit (230) trotz des Empfangs des ersten Ausgabewerts und des zweiten Ausgabewerts von der Spannungserzeugungseinheit (220) nicht bestimmt, dass der Überstrom in dem Nebenschlusswiderstand (210) fließt, diagnostiziert wird, dass die Bestimmungseinheit (230) nicht normal den Überstrom durchführt.

2. Batteriemanagementvorrichtung (200) nach Anspruch 1, wobei die Spannungserzeugungseinheit (220) konfiguriert ist, um den ersten Ausgabewert zu erzeugen, der eine Differenz zwischen der Größe der an den Nebenschlusswiderstand (210) angelegten Spannung, wenn der Ladeüberstrom in dem Nebenschlusswiderstand (210) fließt, und einer Spannung der Batterie ist, und um den zweiten Ausgabewert zu erzeugen, der gleich der Spannung der Batterie ist.

3. Batteriemanagementvorrichtung (200) nach Anspruch 1, wobei die Spannungserzeugungseinheit (220) konfiguriert ist, um den ersten Ausgabewert zu erzeugen, der gleich der Spannung der Batterie ist, und um den zweiten Ausgabewert zu erzeugen, der eine Differenz zwischen der an den Nebenschlusswiderstand (210) angelegten Spannung, wenn der Entladeüberstrom in dem Nebenschlusswiderstand (210) fließt, und der Spannung der Batterie ist.

4. Batteriemanagementvorrichtung (200) nach Anspruch 1, wobei die Bestimmungseinheit (230) aufweist:
einen Verstärker (231), der konfiguriert ist, um den ersten Ausgabewert und den zweiten Ausgabewert zu empfangen und zu verstärken;
einen Komparator (232), der konfiguriert ist, um eine Ausgabe des Verstärkers (231) mit einem Referenzwert zu vergleichen; und
eine Steuerung (233), die konfiguriert ist, um basierend auf der Ausgabe des Verstärkers (231) oder des Komparators (232) zu bestimmen, ob der Ladeüberstrom oder der Entladeüberstrom in dem Nebenschlusswiderstand (210) fließt.

5. Batteriemanagementvorrichtung (200) nach Anspruch 1, wobei die Spannungserzeugungseinheit (220) mehrere Widerstände und mehrere Schalter (222) aufweist, und die mehreren Schalter (222) einen beliebigen von einem Bipolar-Junction-Transistor (BJT) vom Negativ-Positiv-Negativ-Typ (NPN), einem BJT vom Positiv-Negativ-Positiv-Typ (PNP) und einem Metalloxid-Halbleiter-Feldeffekttransistor (MOSFET) aufweisen.

6. Batteriemanagementvorrichtung (200) aufweisend:
einen Nebenschlusswiderstand (210), der mit einer Batterie verbunden ist;
einen ersten Widerstand (R1), der mit dem Nebenschlusswiderstand (210) an einem ersten Knoten (N₁) verbunden ist;
einen zweiten Widerstand (R2), der mit dem ersten Widerstand (R1) an einem zweiten Knoten (N₂) verbunden ist;
einen dritten Widerstand (R3), der mit dem Nebenschlusswiderstand (210) an einem dritten Knoten (N₃) verbunden ist;
einen vierten Widerstand (R4), der mit dem dritten Widerstand (R3) an einem vierten Knoten (N₄) verbunden ist;
einen ersten Schalter (SW1), der mit dem zweiten Widerstand (R2) verbunden ist;
einen zweiten Schalter (SW2), der mit dem vierten Widerstand (R4) verbunden ist; und
eine Bestimmungseinheit (230), die konfiguriert ist, um eine Spannung des zweiten Knotens (N₂) und eine Spannung des vierten Knotens (N₄) mittels der Steuerung des ersten Schalters (SW1) und des zweiten Schalters (SW2) zu empfangen und zu bestimmen, ob ein Überstrom in dem Nebenschlusswiderstand (210) fließt.

7. Batteriemanagementvorrichtung (200) nach Anspruch 6, wobei die Bestimmungseinheit (230) aufweist:
einen Verstärker (231), der konfiguriert ist, um die Spannung des zweiten Knotens (N₂) und die Spannung des vierten Knotens (N₄) zu empfangen und eine Differenz dazwischen zu verstärken;
einen Komparator (232), der konfiguriert ist, um eine Ausgabe des Verstärkers (231) mit einem Referenzwert zu vergleichen; und
eine Steuerung (233), die konfiguriert ist, um basierend auf der Ausgabe des Verstärkers (231) oder des Komparators (232) zu bestimmen, ob der Ladeüberstrom oder der Entladeüberstrom in dem Nebenschlusswiderstand (210) fließt.

8. Batteriemanagementvorrichtung (200) nach Anspruch 7, wobei die Steuerung (233) konfiguriert ist, um den ersten Schalter (SW1) und den zweiten Schalter (SW2) zu steuern, um den ersten Schalter (SW1) kurzzuschließen und den zweiten Schalter (SW2) zu öffnen, um den Ladeüberstrom zu erfassen, und um den zweiten Schalter (SW2) kurzzuschließen und den ersten Schalter (SW1) zu öffnen, um den Entladeüberstrom zu erfassen.

9. Batteriemanagementvorrichtung (200) nach Anspruch 8, wobei die Steuerung (233) konfiguriert ist, um sowohl den ersten Schalter (SW1) als auch den zweiten Schalter (SW2) in einer Situation zu öffnen, in der die Batterie geladen oder entladen wird.

10. Batteriemanagementvorrichtung (200) nach Anspruch 8, ferner aufweisend ein Relais, das mit dem Nebenschlusswiderstand (210) verbunden ist,
wobei das Relais durch ein Steuersignal der Steuerung (233) gesteuert wird und die Steuerung (233) konfiguriert ist, um das Relais zu öffnen, wenn der erste Schalter (SW1) oder der zweite Schalter (SW2) kurzgeschlossen ist.

11. Batteriemanagementvorrichtung (200) nach Anspruch 6, wobei der erste Schalter (SW1) und der zweite Schalter (SW2) einen beliebigen von einem Bipolar-Junction-Transistor (BJT) vom Positiv-Negativ-Positiv-Typ (PNP), einem BJT vom Negativ-Positiv-Negativ-Typ (NPN) und einem Metalloxid-Halbleiter-Feldeffekttransistor (MOSFET) aufweisen.

12. Batteriemanagementvorrichtung (200) nach Anspruch 6, wobei Größen des ersten Widerstands (R1) und des zweiten Widerstands (R2) so eingestellt sind, dass eine Differenz zwischen einer Größe der Spannung des zweiten Knotens (N₂) und einer Größe der Spannung der Batterie der Größe der an den Nebenschlusswiderstand (210) angelegten Spannung entspricht, wenn der Überstrom während des Ladens der Batterie fließt, und Größen des dritten Widerstands (R3) und des vierten Widerstands (R4) so eingestellt sind, dass eine Differenz zwischen einer Größe der Spannung des vierten Knotens (N₄) und der Größe der Spannung der Batterie der Größe der an den Nebenschlusswiderstand (210) angelegten Spannung entspricht, wenn der Überstrom während des Entladens der Batterie fließt.

## Revendications

1. Appareil de gestion de batterie (200), comprenant :
une résistance shunt (210) connectée à une batterie ;
une unité de génération de tension (220) configurée pour générer une première valeur de sortie et une deuxième valeur de sortie, présentant une différence entre elles correspondant à une amplitude d'une tension appliquée à la résistance shunt (210),
l'unité de génération de tension (220) étant configurée en outre pour générer la première valeur de sortie et la deuxième valeur de sortie dans un état où une surintensité de charge ou une surintensité de décharge ne circule pas dans la résistance shunt (210),
la différence entre la première valeur de sortie et la deuxième valeur de sortie correspondant à l'amplitude de la tension appliquée à la résistance shunt (210) lorsqu'une surintensité de charge ou une surintensité de décharge circule dans la résistance shunt (210) ; et
un module de détermination (230) configuré pour recevoir la première valeur de sortie et la deuxième valeur de sortie, et pour déterminer si la surintensité de charge ou la surintensité de décharge circule dans la résistance shunt (210),
dans lequel, lorsque le module de détermination (230) n'est pas en mesure de déterminer que la surintensité circule dans la résistance shunt (210) en dépit de la réception de la première valeur de sortie et de la deuxième valeur de sortie de l'unité de génération de tension (220), le diagnostic est que le module de détermination (230) ne parvient pas à effectuer normalement la surintensité.

2. Appareil de gestion de batterie (200) selon la revendication 1, l'unité de génération de tension (220) étant configurée pour générer la première valeur de sortie, qui est une différence entre l'amplitude de la tension appliquée à la résistance shunt (210) lorsque la surintensité de charge circule dans la résistance shunt (210) et une tension de la batterie, et pour générer la deuxième valeur de sortie qui est égale à la tension de la batterie.

3. Appareil de gestion de batterie (200) selon la revendication 1, l'unité de génération de tension (220) étant configurée pour générer d'une part la première valeur de sortie égale à la tension de la batterie, d'autre part la deuxième valeur de sortie, qui est une différence entre la tension appliquée à la résistance shunt (210) lorsque la surintensité de décharge circule dans la résistance shunt (210) et la tension de la batterie.

4. Appareil de gestion de batterie (200) selon la revendication 1, l'unité de détermination (230) comprenant :
un amplificateur (231) configuré pour recevoir et amplifier la première valeur de sortie et la deuxième valeur de sortie ;
un comparateur (232) configuré pour comparer une sortie de l'amplificateur (231) avec une valeur de référence ; et
un contrôleur (233) configuré pour déterminer si la surintensité de charge ou la surintensité de décharge circule dans la résistance shunt (210), en fonction de la sortie de l'amplificateur (231) ou du comparateur (232).

5. Appareil de gestion de batterie (200) selon la revendication 1, l'unité de génération de tension (220) comprenant une pluralité de résistances et une pluralité de commutateurs (222), et la pluralité de commutateurs (222) comprenant un quelconque des transistors à jonction bipolaire (BJT) du type négatif-positif-négatif (NPN), d'un BJT du type positif-négatif-positif (PNP), et d'un transistor à effet de champ de semi-conducteur d'oxyde (MOSFET).

6. Appareil de gestion de batterie (200), comprenant :
une résistance shunt (210) connectée à une batterie ;
une première résistance (R1) connectée à la résistance shunt (210) au niveau d'un premier nœud (N₁);
une deuxième résistance (R2) connectée à la première résistance (R1) au niveau d'un deuxième nœud (N₂);
une troisième résistance (R3) connectée à la résistance shunt (210) au niveau d'un troisième nœud (N₃);
une quatrième résistance (R4) connectée à la troisième résistance (R3) au niveau d'un quatrième nœud (N₄);
un premier commutateur (SW1) connecté à la deuxième résistance (R2) ;
un deuxième commutateur (SW2) connecté à la quatrième résistance (R4) ; et
un module de détermination (230) configuré pour recevoir une tension du deuxième nœud (N₂) et une tension du quatrième nœud (N₄) au moyen de la commande du premier commutateur (SW1) et du deuxième commutateur (SW2), et pour déterminer si une surintensité circule dans la résistance shunt (210).

7. Appareil de gestion de batterie (200) selon la revendication 6, l'unité de détermination (230) comprenant :
un amplificateur (231) configuré pour recevoir la tension du deuxième nœud (N₂) et la tension du quatrième nœud (N₄) et amplifier une différence entre elles ;
un comparateur (232) configuré pour comparer une sortie de l'amplificateur (231) avec une valeur de référence ; et
un contrôleur (233) configuré pour déterminer si la surintensité de charge ou la surintensité de décharge circule dans la résistance shunt (210), d'après la sortie de l'amplificateur (231) ou du comparateur (232).

8. Appareil de gestion de batterie (200) selon la revendication 7, le contrôleur (233) étant configuré pour commander le premier commutateur (SW1) et le deuxième commutateur (SW2), pour court-circuiter le premier commutateur (SW1), et pour ouvrir le deuxième interrupteur (SW2) afin de détecter la surintensité de charge, et pour court-circuiter le deuxième commutateur (SW2) et ouvrir le premier commutateur (SW1) afin de détecter la surintensité de décharge.

9. Appareil de gestion de batterie (200) selon la revendication 8, le contrôleur (233) étant configuré pour ouvrir à la fois le premier commutateur (SW1) et le deuxième commutateur (SW2) dans une situation où la batterie est chargée ou déchargée.

10. Appareil de gestion de batterie (200) selon la revendication 8, comprenant en outre un relais connecté à la résistance shunt (210),
le relais étant commandé par un signal de commande du contrôleur (233), et le contrôleur (233) étant configuré pour ouvrir le relais lorsque le premier commutateur (SW1) ou le deuxième commutateur (SW2) est court-circuité.

11. Appareil de gestion de batterie (200) selon la revendication 6, le premier commutateur (SW1) et le deuxième commutateur (SW2) comprenant un quelconque d'un transistor à jonction bipolaire (BJT) du type positif-négatif-positif (PNP), d'un BJT du type négatif-positif-négatif (NPN), et d'un transistor à effet de champ de semi-conducteur d'oxyde (MOSFET).

12. Appareil de gestion de batterie (200) selon la revendication 6, des amplitudes de la première résistance (R1) et de la deuxième résistance (R2) étant réglées de sorte qu'une différence entre une amplitude de la tension du deuxième nœud (N₂) et une amplitude de la tension de la batterie corresponde à l'amplitude de la tension appliquée à la résistance shunt (210) lorsque la surintensité circule au cours de la charge de la batterie, et des amplitudes de la troisième résistance (R3) et de la quatrième résistance (R4) étant réglées de sorte qu'une différence entre une amplitude de la tension du quatrième nœud (N₄) et l'amplitude de la tension de la batterie corresponde à l'amplitude de la tension appliquée à la résistance shunt (210) lorsque la surintensité circule au cours de la décharge de la batterie.
